# EUROPEAN PATENT APPLICATION

(11) **EP 4 749 315 A1**
(43) Date of publication of application: **27.05.2026**
(21) Application number: 24214415.2
(22) Date of filing: 21.11.2024
(51) Int. Cl.: G01R 33/46, G01R 33/563

(54) **METHOD AND DEVICE FOR CONTROLLING AN MRI-SYSTEM**

(71) Applicant: Siemens Healthineers AG, 91301 Forchheim (DE)
(72) Inventor: Groß-Weege, Nicolas, 90459 Nürnberg (DE); Liu, Wei, 91052 Erlangen (DE)
(74) Representative: Siemens Healthineers Patent Attorneys

(57) **Abstract**

The invention pertains to a method for controlling an MRI-system (1), comprising the steps:
- providing a TONE-pulse scheme comprising multiple ramped RF-pulses,
- applying TONE-pulses (T) according to the TONE-pulse scheme in form of pulse-trains (P) with a binomial application-scheme to the MRI-system (1).

Furthermore, the invention describes a device, a control device and a MRI-system.

## Description

The invention describes a method and a device for controlling an MRI-system, a control device for an MRI-system and an MRI-system.

Magnetic resonance imaging (MRI) is commonly used in medicine to provide images of the inside of a patient. For example, Time-Of-Flight (TOF) magnetic resonance angiography (MRA) is commonly utilized for imaging blood vessels in the head and body, providing crucial information for diagnosing various vascular abnormalities. This technique utilizes incoming unsaturated spins as an intrinsic contrast agent, with vascular images obtained through maximum-intensity projection (MIP) onto acquired images.

In TOF-MRA, flow-related enhancement is highest for vessels entering the imaging slab, with saturation increasing as vessels travel deeper into the slab due to repetitive radiofrequency (RF) pulses. To mitigate this saturation effect, the variable flip-angle excitation technique, known as "Tilted Optimized Non-saturating Excitation" (TONE), has been proposed (see e.g. Atkinson D et.al "Improved MR angiography magnetization transfer suppression with variable flip angle excitation and increased resolution"; Radiology 1994; 190:890-894).

By linearly varying the flip angle (FA) across the excitation volume, less saturation occurs in the proximal part of the slab, resulting in better depiction of peripheral or smaller vessels in the distal region. Additionally, flow saturation effects can be further reduced through a technique called "Multiple Overlapping Thin Slab Acquisition" (MOTSA, see e.g. Blatter et al. "Cerebral MR angiography with multiple overlapping thin slab acquisition. Part II. Early clinical experience"; Radiology 1992; 183:379-389). This method involves the sequential acquisition of several overlapping slabs, each typically less than 5 cm thick. Due to the restricted slab thickness, signal loss from saturation effects is relatively minimized.

Moreover, TOF-MRA inherently produces T1-weighted images, causing tissues with short T1 relaxation times, such as fat, to appear bright and potentially interfere with vessel depiction. For example, fatty tissue surrounding blood vessels, such as the ophthalmic arteries or branches of the external carotid artery, may obscure vessel visibility. Implementing fat suppression techniques can enhance vessel visualization, particularly in Maximum-Intensity Projection (MIP) reconstructed images, by reducing signals from fatty bone marrow, orbital fat, and subcutaneous fat (see e.g. Anderson et al. "Artifacts in maximum-intensity-projection display of MR angiograms"; AJR Am J Roentgenol 1990;154:623-629). The use of a chemical shift-selective fat saturation pulse has been shown to significantly improve the visualization of vascular anatomy (see e.g. Robinson et al. "Fat suppression in combination with multiple overlapping thin-slab 3-D acquisition MR angiography: proposed technique for improved vessel visualization"; AJNR 1992;13:1429-34).

However, employing a nonselective fat saturation pulse may inadvertently suppress water spins outside the magnet isocenter, since the saturation pulse relies on a homogeneous B0 field and the B0 homogeneity degrades with distance to the isocenter. Inflowing of suppressed water spins in the imaging volume results in dark appearance on MRA images (see e.g. Hatabu et al. "Application of a spectral-spatial water excitation for MR angiography"; Eur J Radiol 1999; Mar;29(3):253-8). Additionally, the minimal Repetition Time (TR) may increase due to the duration of the fat saturation pulse and corresponding spoiler gradient.

Spectral-spatial water excitation has emerged as an alternative to conventional non-selective fat suppression for distinguishing arteries from surrounding fat tissues and enhancing vessel visualization, particularly in MRA images. This technique employs RF excitation specifically tailored to water protons in the chosen slice, thereby suppressing fat signals. As it suppresses fat spatially, i.e., only in the chosen slice, it effectively addresses signal voids in contrast to chemical shift-selective fat saturation pulses as discussed above, while exerting minimal impact on the repetition time. Thus, spectral-spatial excitation is advantageous not only for angiography, but for any MR-imaging where fat or water should be suppressed.

However, there are no previous reports on the spectral-spatial water excitation pulse featuring a ramp-shaped flip angle distribution, like the TONE-based water excitation pulse.

It is the object of the present invention to improve the known systems and methods and provide a method and a device for controlling an MRI-system, a control device for an MRI-system and a MRI-system, for overcoming the above described problems. Especially the object of the invention is to provide a water excitation pulse with ramp-shaped flip angle distribution.

This object is achieved by a method according to claim 1, a device according to claim 11, a control device according to claim 12 and a MRI-system according to claim 13.

A method according to the invention serves for controlling an MRI-system. It comprises the following steps:
- providing a TONE-pulse scheme comprising multiple ramped RF-pulses,
- applying the TONE-pulses according to the TONE-pulse scheme in form of pulse-trains with a binomial application-scheme to the magnetic resonance imaging system.

The method is suited for controlling a Magnetic Resonance Imaging system (MRI-system). That means that this method can provide a pulse sequence comprising special pulse-trains. Here, the expression "pulse-train" means an arrangement of multiple TONE-pulses (and preferably also corresponding slice/slab selective gradients) in order to excite a Region of interest, especially to receive data for one k-space coordinate. Since a pulse train is an excitation sequence, it could also be designated as "excitation kernel". A "pulse sequence" is a sequence of multiple pulse-trains (multiple excitation kernels) in order to acquire an MRI-image (all points of the desired k-space). The MRI-system can then apply magnetic signals according to the pulse sequence with its coils (e.g. RF-signals and gradients) to an object to be examined. Since the pulse sequence is very advantageous to separate fat and water, a patient in form of a human or animal is a preferred examination-object.

The method comprises at least the two described steps, but may comprise further (known) steps in order to provide a complete pulse sequence that could directly be applied by an MRI-system. It should be noted that in general, only one single type of pulse-train may be generated and then applied in multiple variations in order to acquire a targeted slice or slab. As said above, the total of applied pulse-trains could be the pulse sequence (here the pulse trains comprise all other pulses needed for image recording, e.g. gradients). However, it is only necessary that the pulse-trains comprise the TONE-pulses. Thus, in the pulse sequence, gradients could be added besides the pulse-trains.

It is preferred that first, TONE-pulses according to the TONE-pulse scheme are arranged in form of pulse-trains with a binomial application-scheme, then these pulse trains are integrated into a pulse sequence and then this pulse sequence is applied to the MRI system.

First, a TONE-pulse scheme is provided. A TONE-pulse scheme is a sequence of multiple ramped Radio Frequency (RF) pulses. These pulses have a specific shape defined by their amplitude and duration and are generally known in the art. A more generic name of the TONE-pulse scheme could be "Ramped RF-pulses". It could also be referred to these TONE-pulses as "variable ramped flip angle pulses ".

In general, there are two variants of TONE-pulses: Symmetric pulses with one big peak in the middle and a number of smaller peaks decreasing to the left and right and asymmetric pulses in form of a row of multiple decreasing pulses (all seen in time domain). They could be applied in normal order or in reversed order, wherein for symmetric pulses the order could only be seen by looking at the phase part of the pulse in time domain or by looking at the frequency domain. The asymmetry factor can be defined flexibly. If set to 0.5, it will result in a symmetric shape.

Looking at asymmetric pulses, the order of the decreasing pulses also changes with reversed order (normal: amplitude increasing in time domain, reversed: amplitude decreasing in time domain). A TONE-pulse scheme could be understood as a "symmetric" or "asymmetric" pulse, wherein the temporal shape (and number) of the peaks are defined.

While TONE-pulses are known in the art, an application of these TONE-pulses in form of pulse-trains with a binomial application-scheme is not known in the art.

As implied above, a pulse-train is a sequence of pulses applied at a specific "rhythm", i.e. the general shape of the pulses is not changed, but the pulses are arranged in form of a special order and especially also the amplitude of the pulses is scaled.

According to the invention, a binomial scheme is used, which means that the amplitudes and especially also the inter-pulse delays vary according to a mathematical formula derived from the binomial formulae. The easiest binomial scheme is 1-1, followed by 1-2-1 and 1-3-3-1. In general, the binomial scheme refers to the numbers of a row in Pascal' triangle. This binomial scheme refers to the flip angle A that should be applied by the MRI-scanner. The angle A is depending from the TONE-pulses applied in one binary sequence. In a 1-1 binomial application-scheme, two TONE-pulses are arranged as an A/2-A/2-pair (for A=90° this would be a 45°-45°-pair). In a 1-2-1 binomial application-scheme, three TONE-pulses are arranged as an A/4-A/2-A/4-triplet (for A=90° this would be a 22.5°-45°-22.5° triplet). In a 1-3-3-1 binomial application-scheme four TONE-pulses would be arranged as an A/8-3A/8-3A/8-A/8- quadruplet (for A=90° this would be a 11.25°-33.75°-33.75°-11.25°-quadruplet). This sequence would be applied multiple times in an MRI pulse sequence for any point in k-space. The inclusion of more sub-pulses enhances spectral selection but prolongs the total pulse duration.

A device according to the invention for controlling an MRI-system comprises the following components:
- a TONE-module, designed for providing TONE-pulses according to a TONE-pulse scheme comprising multiple ramped RF-pulses and
- an application-module, designed for applying the TONE-pulses in form of pulse-trains with a binomial application-scheme to the MRI-system.

The device is preferably designed for performing the method according to the invention. The function of the components of the device is described above.

The TONE-module generates the TONE-pulses according to the TONE-pulse scheme. The TONE ramp is used to indicate the flip angle distribution along the slice direction, for example, a ramp value of 0.7 results excitation profile varies from 16.5° to 23.5° when the target flip angle is 20°. These TONE-pulses are then used in the pulse-trains. The TONE-module could for example be a function-generator designed to emit TONE-pulses. Thus, the TONE-module is responsible for creating the specific pulse sequence required for MRI imaging. For example, the TONE-module could be designed to generate symmetric or asymmetric TONE-pulses in normal order and reversed order and to scale the amplitude of these TONE-pulses.

The application-module is designed to form pulse-trains from several TONE-pulses and to apply them to an MRI-system. Thus, it is preferably designed to define whether symmetric or asymmetric pulses are used (e.g. depending on a preference), to specify an order (normal or reversed) and especially to define an amplitude (especially in the case there are more than two pulses in the pulse-train). The application-module then sends parameters for the pulses to the TONE-module so that the desired TONE-pulses could be arranged in the pulse-trains (i.e. in excitation kernels). Preferably, the application-module is also designed to insert suitable fill-times between the TONE-pulses, preferably depending on the desired phase evolution between water and fat spins that supporting selective water excitation. Concerning the amplitude and the order, they depend on the selected binomial application-scheme and a selected monopolar or bipolar application-scheme. It is preferred that the application-module is designed to arrange TONE-pulses according to the TONE-pulse scheme in form of pulse-trains with a binomial application-scheme, then to integrate these pulse trains into a pulse sequence and then apply this pulse sequence to an MRI system.

For example, the application-module may comprise commands according to the binomial scheme (e.g. amplitudes of three TONE-pulses: X, 2X and X), and information about time delays between the three pulses and to the next pulse train. The TONE-module comprise values for parameters (scheme) for the TONE-pulses, e.g. "symmetric", following the given shape-formula f(t). For applying the pulse-trains, the application-module then requests TONE-pulses from the TONE-module at suited time-points by sending a requested amplitude to the TONE-module. The TONE-module receives the amplitude and generates an according TONE-pulse with this amplitude. The TONE-pulses generated at certain time-points are then applied.

Concerning a monopolar application-scheme, the order of the TONE-pulses should not alter. One order is selected and applied. Concerning a bipolar application-scheme, the order should alternate between normal order and reversed order (starting with normal or reversed order).

Concerning the binomial application-scheme, the amplitude may be the same (1-1-scheme) or two different amplitudes are used (1-2-1-scheme and 1-3-3-1-scheme). Also more different amplitudes may be used (e.g. by applying the 1-4-6-4-1-scheme). For example, concerning a bipolar 1-3-3-1-scheme, a normal TONE-pulse with a predefined amplitude X is applied, followed by a reversed TONE-pulse with the amplitude 3X, a normal TONE-pulse with the amplitude 3X and a reversed TONE-pulse with the amplitude X. The Application-module ensures that the pulse sequence is provided to the MRI system for applying the pulse trains (excitation kernels) in the course of an examination.

A control device according to the invention for an MRI-system comprises a device according to the invention or designed to perform a method according to the invention.

A MRI-system according to the invention comprises the control device according to the invention.

Some units or modules of the invention mentioned above can be completely or partially realized as software modules running on a processor of a computing system. A realization largely in the form of software modules can have the advantage that applications already installed on an existing computing system can be updated, with relatively little effort, to install and run these units of the present application. The object of the invention is also achieved by a computer program product with a computer program that is directly loadable into the memory of a computing system, and which comprises program units to perform the steps of the methods, at least those steps that could be executed by a computer, when the program is executed by the computing system. In addition to the computer program, such a computer program product can also comprise further parts such as documentation and/or additional components, also hardware components such as a hardware key (dongle etc.) to facilitate access to the software.

A computer readable medium such as a memory stick, a hard-disk or other transportable or permanently-installed carrier can serve to transport and/or to store the executable parts of the computer program product so that these can be read from a processor unit of a computing system. A processor unit can comprise one or more microprocessors or their equivalents.

Particularly advantageous embodiments and features of the invention are given by the dependent claims, as revealed in the following description. Features of different claim categories may be combined as appropriate to give further embodiments not described herein.

According to a preferred method, the TONE-pulses are designed for an excitation flip angle A, that is preferably 90° (could also be <90°), but may also be 180° or another angle. The TONE-pulses are preferably applied in form of a 1-1 binomial application-scheme with two TONE-pulses arranged as an A/2-A/2-pair (e.g. 45°-45°-pair for a flip angle of 90°). Alternatively preferred, the TONE-pulses are applied in form of a 1-2-1 binomial application-scheme with three TONE-pulses arranged as an A/4-A/2-A/4-triplet (e.g. a 22.5°-45°-22.5° triplet for a flip angle of 90°). Alternatively preferred, the TONE-pulses are applied in form of a 1-3-3-1 binomial application-scheme with four TONE-pulses arranged as an A/8-3A/8-3A/8-A/8- quadruplet (e.g. a 11.25°-33.75°-33.75°-11.25°-quadruplet for a flip angle of 90°). The inclusion of more sub-pulses enhances spectral selection but prolongs the total pulse duration. The pattern is not limited to above ones. Binomial pulses have flip angles that follow the pattern of Pascale's triangle and could also be binomial application-schemes like 1-4-6-4-1 or 1-5-10-10-5-1 and so on.

According to a preferred method, in the pulse-trains only symmetric or only asymmetric TONE-pulses are applied. That means that there are only symmetric TONE-pulses with a maximum signal in the middle or only asymmetric TONE-pulses with a maximum signal at the beginning or the end (relating to normal or reverse order).

According to a preferred method, in the course of the pulse-trains a gradient-scheme is applied that is monopolar for all TONE-pulses or bipolar for all TONE-pulses of the pulse-train It should be noted that there are typical selective gradient modules when binomial pulses are used. Thus, a "monopolar gradient scheme" is the gradient scheme used for monopolar TONE-pulses and a "bipolar gradient scheme" is the gradient scheme used for bipolar TONE-pulses and

It is preferred that the TONE-pulses have amplitudes that are scaled according to the numbers of the binomial application-scheme (e.g. 1-1, 1-2-1 or 1-3-3-1). For monopolar gradients, the TONE-pulses have the same RF-shape that has identical phase. For bipolar gradients, the TONE-pulses have alternating RF-shapes that have the same phase patterns and amplitude patterns mirrored in time. That means that there could be used only one single general shape for all TONE-pulses, wherein this shape could be scaled in amplitude or the phases and amplitudes could be mirrored in time. Thus, for a monopolar 1-3-3-1-scheme, there are only TONE-pulses with identical phases, but scaled in amplitude X according to the scheme X-3X-3X-X. For a bipolar 1-2-1 scheme, there are TONE-pulses with identical phases and the amplitude X for the "1"-parts and a TONE-pulse with the phase and amplitude mirrored in time and the amplitude 2X for the "2"-part.

According to a preferred method, for the monopolar gradient scheme, the gradient strengths of the slice-selective gradients match and preferably an additional rephasing gradient is inserted between the TONE-pulses.

According to a preferred method, for a bipolar gradient scheme, the magnitudes of the gradient strengths of the slice-selective gradients match with alternating signs. No additional rephasing gradient is needed here which allows a shorter total duration and thus, a shorter TE. As said above, when a bipolar gradient scheme is used in a binomial pulse train, the sign will alternate, following a pattern like 1, -1, 1, -1, and so on.

According to a preferred method, the TONE-pulses are applied in a normal order or in a reversed order. It is preferred that for a monopolar scheme, the TONE-pulses are applied in a similar (or the same) order (all reversed or all normal), and for a bipolar scheme, the TONE-pulses are applied in an alternating order (normal-reversed-normal... or reversed-normal-reversed...). When a bipolar gradient is applied during excitation, both normal and reversed pulse orders should be used in composite pulses following the binomial pattern. For example, in a 1-1 binomial pattern with a bipolar gradient scheme, the first pulse follows the normal order, while the second pulse is in reversed order. In a 1-2-1 binomial pattern with the bipolar gradient scheme, the first pulse is in normal order, the second in reversed order, and the third again in normal order. This means that the reversed order is applied when the composite pulse uses the opposite polarity of the slab-selective gradient. In contrast, with a monopolar gradient scheme (where all composite pulses use the same polarity for the slab-selective gradient), the normal order is used for all composite pulses. The following pulse-train preferably have the same pattern.

According to a preferred method, the TONE-pulses are arranged such in the pulse-trains that the ratio of a repetition time TR divided by an echo time TE, TR/TE is bigger than 3.5 preferably 4 or bigger and/or smaller than 5.5, preferably smaller than 5. In principle, this ration could be chosen, as it can be applied with any TE/TR settings.

According to a preferred method, the pulse-trains are designed for water excitation, especially for an angiography. The method according to the invention is especially advantageous for angiography.

According to a preferred method, the pulse-trains are designed for Echo-Planar-Imaging (EPI) or Gradient-Recalled Echo (GRE), preferably for Time of Flight (TOF) imaging with Multiple Overlapping Thin Slab Acquisition (MOTSAR). All these procedures are well known in the art, however, the invention is especially advantageous for these procedures.

According to a preferred method, a bipolar gradient scheme is used and the flow compensation in slice selective direction is adapted. Since a flow compensation method is often based on a first gradient moment nulling, in a preferred method, for adaption, the first moment is accumulated during the pulse train and a compensation gradient is added after that.

Other objects and features of the present invention will become apparent from the following detailed descriptions considered in conjunction with the accompanying drawings. It is to be understood, however, that the drawings are designed solely for the purposes of illustration and not as a definition of the limits of the invention.
Figure 1 shows a schematic representation of an MRI-system with a device according to the invention.
Figure 2 shows a symmetric, normal TONE-pulse.
Figure 3 shows a symmetric, reversed TONE-pulse.
Figure 4 shows an asymmetric, normal TONE-pulse.
Figure 5 shows an asymmetric, reversed TONE-pulse.
Figure 6 shows a pulse-train with two symmetric TONE-pulses in a 1-1 binomial application-scheme with encoding gradients in a bipolar manner.
Figure 7 shows a pulse-train with three symmetric TONE-pulses in a 1-2-1 binomial application-scheme with encoding gradients in a bipolar manner.
Figure 8 shows a comparison of images of the state of the art with images recorded with the invention.
Figure 9 shows a pulse-train with two asymmetric TONE-pulses in a 1-1 binomial application-scheme with encoding gradients in a bipolar manner.
Figure 10 shows a pulse-train with three asymmetric TONE-pulses in a 1-2-1 binomial application-scheme with encoding gradients in a bipolar manner.
Figure 11 shows a comparison of images acquired with a prior art method and with the invention.
Figure 12 shows three symmetric TONE-pulses in a 1-2-1 binomial application-scheme with encoding gradients in a monopolar manner.
Figure 13 shows three asymmetric TONE-pulses in a 1-2-1 binomial application-scheme with encoding gradients in a monopolar manner.

In the diagrams, like numbers refer to like objects through-out. Objects in the diagrams are not necessarily drawn to scale.

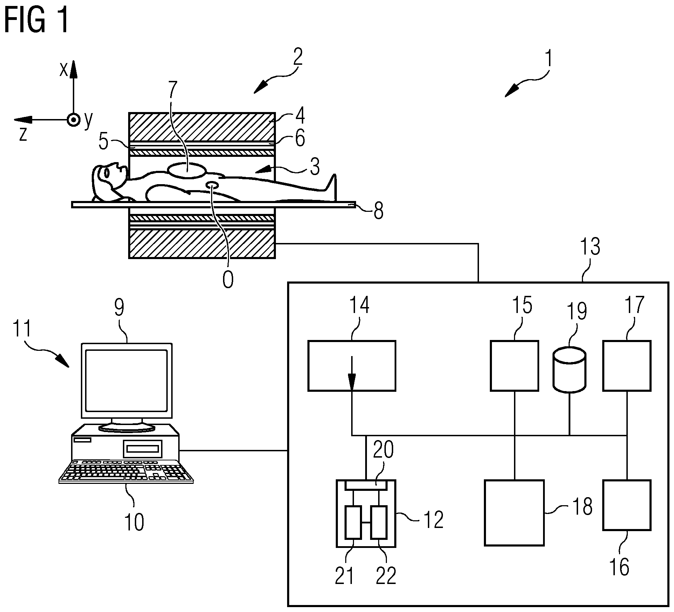

Figure 1 shows a schematic representation of a magnetic resonance imaging system 1 ("MRI-system" 1). The MRI system 1 includes the actual magnetic resonance scanner (data acquisition unit) 2 with an examination space 3 or patient tunnel in which a patient or test person is positioned on a driven bed 8, in whose body the actual examination object O is located.

The magnetic resonance scanner 2 is typically equipped with a basic field magnet system 4, a gradient system 6 as well as an RF transmission antenna system 5 and an RF reception antenna system 7. In the shown exemplary embodiment, the RF transmission antenna system 5 is a whole-body coil permanently installed in the magnetic resonance scanner 2, in contrast to which the RF reception antenna system 7 is formed as local coils (symbolized here by only a single local coil) to be arranged on the patient or test subject. In principle, however, the whole-body coil can also be used as an RF reception antenna system, and the local coils can respectively be switched into different operating modes.

The basic field magnet system 4 is designed that MR-images can be recorded. It here is designed in a typical manner so that it generates a basic magnetic field in the longitudinal direction of the patient, i.e. along the longitudinal axis of the magnetic resonance scanner 2 that proceeds in the z-direction. The gradient system 6 typically includes individually controllable gradient coils in order to be able to switch (activate) gradients in the x-direction, y-direction or z-direction independently of one another.

The MRI system 1 shown here is a whole-body system with a patient tunnel into which a patient can be completely introduced. However, in principle the invention can also be used at other MRI systems, for example with a laterally open, C-shaped housing, as well as in smaller magnetic resonance scanners in which only one body part can be positioned.

Furthermore, the MRI-system 1 has a central control device 13 that is used to control the MRI system 1. This central control device 13 includes a sequence control unit 14 for measurement sequence control. With this sequence control unit 14, the series of radio-frequency pulses (RF pulses) and gradient pulses can be controlled depending on a selected pulse sequence or, respectively, a series of multiple pulse sequence to acquire multiple magnetic resonance images within a measurement session. For example, such a series of pulse sequence can be predetermined within a measurement or control protocol. Different control protocols for different measurements or measurement sessions are typically stored in a memory 19 and can be selected by and operator (and possibly modified as necessary) and then be used to implement the measurement.

To output the individual RF pulses of a pulse sequence, the central control device 13 has a radio-frequency transmission device 15 that generates and amplifies the RF pulses and feeds them into the RF transmission antenna system 5 via a suitable interface (not shown in detail). To control the gradient coils of the gradient system 6, the control device 13 has a gradient system interface 16. The sequence control unit 14 communicates in a suitable manner with the radio-frequency transmission device 15 and the gradient system interface 16 to emit the pulse sequence.

Moreover, the control device 13 has a radio-frequency reception device 17 (likewise communicating with the sequence control unit 14 in a suitable manner) in order to acquire magnetic resonance signals (i.e. raw data) for the individual measurements, which magnetic resonance signals are received in a coordinated manner from the RF reception antenna system 7 within the scope of the pulse sequence.

A reconstruction unit 18 receives the acquired raw data and reconstructs magnetic resonance image data therefrom for the measurements. This reconstruction is typically performed on the basis of parameters that may be specified in the respective measurement or control protocol. For example, the image data can then be stored in a memory 19.

Operation of the central control device 13 can take place via a terminal 10 with an input unit and a display unit 9, via which the entire MRI system 1 can thus also be operated by an operator. MR images can also be displayed at the display unit 9, and measurements can be planned and started by means of the input unit (possibly in combination with the display unit 9), and in particular suitable control protocols can be selected (and possibly modified) with suitable series of pulse sequence as explained above.

The control device 13 comprises a device 12 designed to perform the method according to the invention. This system 12 comprises, besides a data-interface 20 for receiving and outputting data, a TONE-module 21, and an application-module 22. The TONE-module 21 is designed for providing TONE-pulse according to a predefined TONE-pulse scheme comprising multiple ramped RF-pulses, as shown in the following figures. The application-module is designed for applying the TONE-pulses T in form of pulse-trains P with a binomial application-scheme into a pulse sequence and applying this pulse sequence to the magnetic resonance imaging system 1. Example for such pulse-trains P are shown in the following figures.

The MRI system 1 according to the invention, and in particular the control device 13, can have a number of additional components that are not shown in detail but are typically present at such systems, for example a network interface in order to connect the entire system with a network and be able to exchange raw data and/or image data or, respectively, parameter maps, but also additional data (for example patient-relevant data or control protocols).

The manner by which pulses and gradients are applied and suitable raw data are acquired by radiation of such pulses as well as how MR images are reconstructed from the raw data, is known to those skilled in the art and thus need not be explained in detail herein.

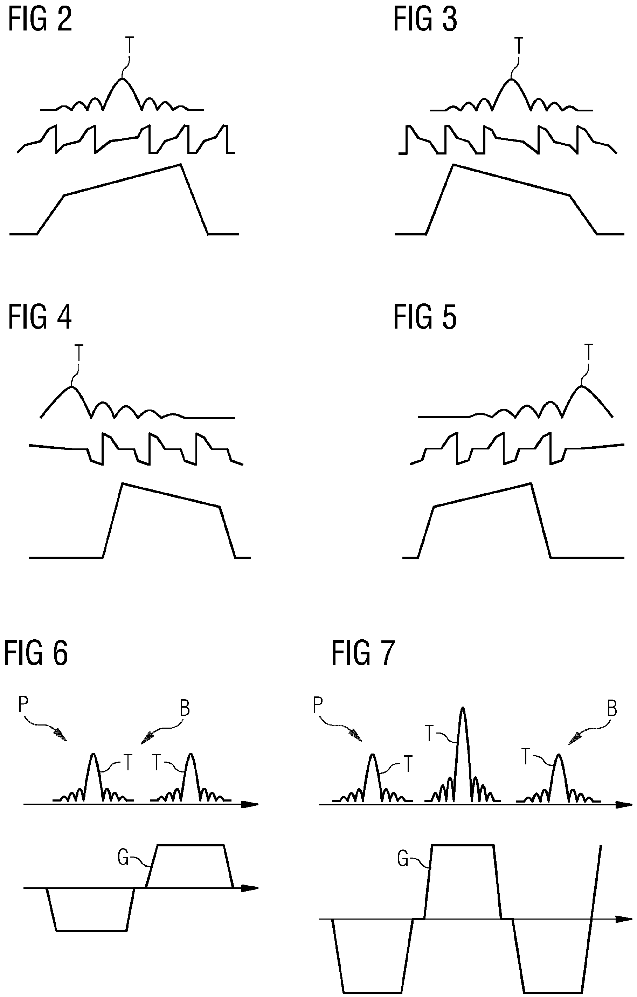

Figure 2 shows a symmetric, normal TONE-pulse T that could be provided by the TONE-module 21 of figure 1. Shown are three rows. The upper row shows the amplitude of the TONE-pulse T in the time domain. That means that the pulse begins with a weak signal, followed by some stronger peaks of increasing amplitude, a prominent center peak and further decreasing peaks such that the TONE-pulse T has a symmetric shape in time. The center row shows the phase-part of the tone-pulse T in time domain. The bottom row shows the slice profile of the TONE-pulse T in frequency domain.

Figure 3 shows a symmetric, reversed TONE-pulse T. Looking at the amplitudes in time domain, it is identical to the TONE-pulse T of figure 2 (since it is symmetric in time), but the phase-pattern and the slice profile in frequency domain are mirrored.

Figure 4 shows an asymmetric, normal TONE-pulse T that could be provided by the TONE-module 21 of figure 1. Looking at the amplitude of the TONE-pulse T in the time domain, the pulse begins with a prominent peak and continues with peaks of decreasing amplitude. The asymmetry factor can be defined flexibly. If set to 0.5, it will result in a symmetric shape. The center row again shows the phase-part of the tone-pulse T in time domain. The bottom row again shows the slice profile of the TONE-pulse T in frequency domain.

Figure 5 shows an asymmetric, reversed TONE-pulse T. Looking at the amplitudes in time domain, the phase-pattern in time domain and the slice profile in frequency domain, they are all mirrored compared to figure 4.

Figure 6 shows a pulse-train P with two symmetric TONE-pulses T in a 1-1 binomial application-scheme B with encoding gradients G in a bipolar manner. One can see in the upper row the amplitudes of these two TONE-pulses T in time domain and below the slice/slab selective gradients G applied together with the TONE-pulses T. This pulse-train P excites the examined object O and echoes can be measured afterwards (not shown).

Figure 7 shows a pulse-train P with three symmetric TONE-pulses T in a 1-2-1 binomial application-scheme B with slice/slab selective gradients G in a bipolar manner. The application of TONE-pulses and gradients G is similar to figure 6 with the difference that there are three TONE-pulses T with altering amplitudes and according gradients G.

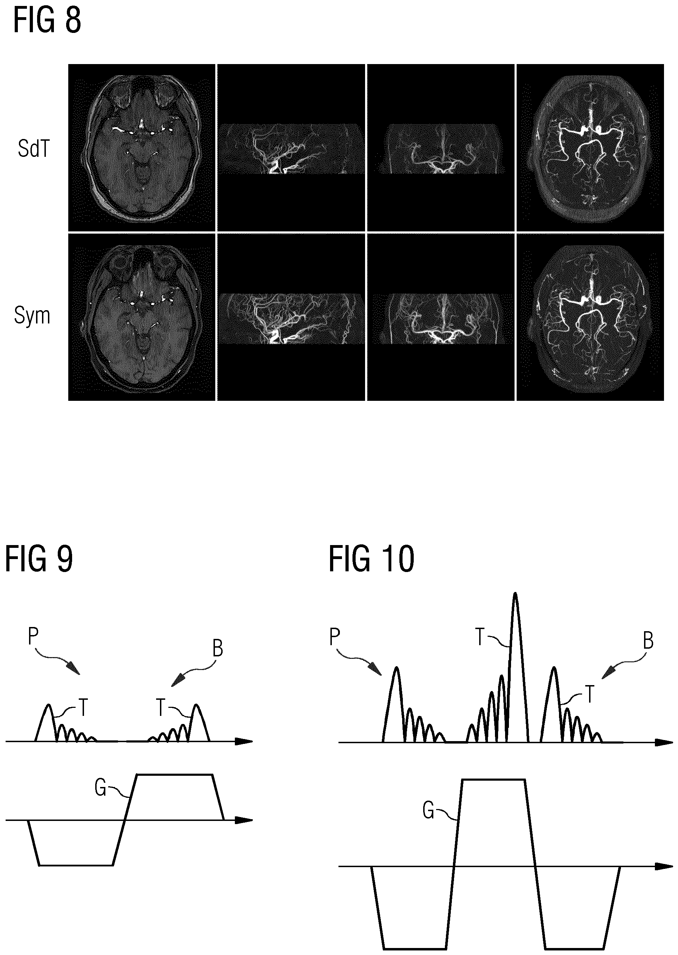

Figure 8 shows a comparison of images of the state of the art with images recorded with the invention. In the above row, the state of the art is shown and below, images recorded with a scheme as shown in figure 6 are shown. It can be seen that the invention clearly suppresses the influence of fat and enhances the signal of vessels.

Figure 9 shows a pulse-train P with two asymmetric TONE-pulses T in a 1-1 binomial application-scheme B with slice/slab selective gradients G in a bipolar manner similar to figure 6. Here the alternating order can be seen since these TONE-pulses T are not symmetric in time.

Figure 10 shows a pulse-train P with three asymmetric TONE-pulses T in a 1-2-1 binomial application-scheme B with encoding gradients G in a bipolar manner similar to figure 7. Here the alternating order can be seen since these TONE-pulses T are not symmetric in time.

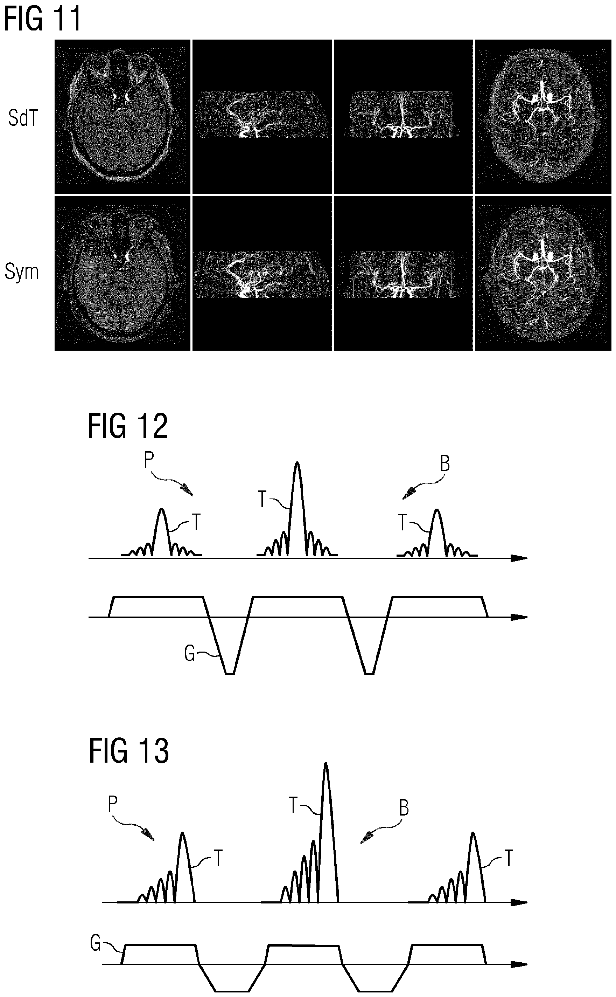

Figure 11 shows a comparison of images acquired with a prior art method and with the invention. In the above row, the state of the art is shown and below, images recorded with a scheme as shown in figure 9 are shown. It can be seen that the invention clearly suppresses the influence of fat and enhances the signal of vessels.

Figure 12 shows a pulse-train P with three symmetric TONE-pulses T in a 1-2-1 binomial application-scheme B with slice/slab selective gradients G in a monopolar manner.

Figure 13 shows a pulse-train P with three asymmetric TONE-pulses in a 1-2-1 binomial application-scheme B with slice/slab selective gradients G in a monopolar manner.

Although the present invention has been disclosed in the form of preferred embodiments and variations thereon, it will be understood that numerous additional modifications and variations could be made thereto without departing from the scope of the invention. For the sake of clarity, it is to be understood that the use of "a" or "an" throughout this application does not exclude a plurality, and "comprising" does not exclude other steps or elements. The expression "a number of" means "at least one". The mention of a "unit" or a "device" does not preclude the use of more than one unit or device. Independent of the grammatical term usage, individuals with male, female or other gender identities are included within the term.

## Claims

1. A method for controlling an MRI-system (1), comprising the steps:
- providing a TONE-pulse scheme comprising multiple ramped RF-pulses,
- applying the TONE-pulses (T) according to the TONE-pulse scheme in form of pulse-trains (P) with a binomial application-scheme to the MRI-system (1).

2. The method according to claim 1, wherein the TONE-pulses (T) are designed for an excitation flip angle A, and applied in form of a
- 1-1 binomial application-scheme with two TONE-pulses (T) arranged as an A/2-A/2-pair,
- 1-2-1 binomial application-scheme with three TONE-pulses (T) arranged as an A/4-A/2-A/4-triplet,
- 1-3-3-1 binomial application-scheme with four TONE-pulses (T) arranged as an A/8-3A/8-3A/8-A/8-quadruplet.

3. The method according to claim 1 or 2, wherein in the pulse train (P) only symmetric or only asymmetric TONE-pulses (T) are applied.

4. The method according to one of the preceding claims, wherein in the course of the pulse-trains (P) a gradient-scheme is applied that is monopolar for all TONE-pulses (T) or bipolar for all TONE-pulses (T) of the pulse-trains (P),
preferably wherein the TONE-pulses (T) have amplitudes that are scaled according to the numbers of the binomial application-scheme and
- for monopolar gradients, have the same RF-shape that has identical phase,
- for bipolar gradients, have alternating RF-shapes that have the same amplitude patterns and phase patterns mirrored in time.

5. The method according to claim 4, wherein
- for the monopolar gradient scheme, the gradient strengths of the slice-selective gradients match and preferably an additional rephasing gradient is inserted between the TONE-pulses (T), and
- for a bipolar gradient scheme, the magnitudes of the gradient strengths of the slice/slab-selective gradients match with alternating signs.

6. The method according to one of the preceding claims, wherein the TONE-pulses (T) are applied in a normal order or in a reversed order, preferably wherein
- for a monopolar scheme, the TONE-pulses (T) are applied in the same order
- for a bipolar scheme, the TONE-pulses (T) are applied in an alternating order.

7. The method according to one of the preceding claims, wherein the TONE-pulses (T) are arranged such in the pulse-trains (P) that the ratio of a repetition time TR divided by an echo time TE, TR/TE is bigger than 3.5 preferably 4 or bigger and/or smaller than 5.5, preferably smaller than 5.

8. The method according to one of the preceding claims, wherein the pulse-trains (P) are designed for water excitation, especially for an angiography.

9. The method according to one of the preceding claims, wherein the pulse-trains (P) are designed for Echo-Planar-Imaging or Gradient-Recalled Echo, preferably for Time of Flight imaging with Multiple Overlapping Thin Slab Acquisition.

10. The method according to one of the preceding claims, wherein a bipolar gradient scheme is used and the flow compensation in slice selective direction is adapted.

11. A device (12) for controlling an MRI-system (1), comprising:
- a TONE-module (21), designed for generating TONE-pulses (T) according to a TONE-pulse scheme comprising multiple ramped RF-pulses and
- an application-module (22), designed for applying the TONE-pulses (T) in form of pulse-trains (P) with a binomial application-scheme to the MRI-system (1).

12. A control device (13) for an MRI-system (1) comprising a device according to claim 11 and/or designed to perform a method according to any of claims 1 to 10.

13. An MRI-system (1), comprising the control device (13) according to claim 12.

14. A computer program product comprising instructions which, when the program is executed by a computer, cause the computer to carry out the steps of the method of any of claims 1 to 10.

15. A computer-readable storage medium comprising instructions which, when executed by a computer, cause the computer to carry out the steps of the method of any of claims 1 to 10.
